Europäisches Patentamt

European Patent Office

Office européen des brevets

(19)

(11) Publication number: **0 215 583**
**A2**

(12)

# EUROPEAN PATENT APPLICATION

(21) Application number: **86306397.0**

(22) Date of filing: **19.08.86**

(51) Int. Cl.⁴: **H 01 L 27/06**
**H 01 L 23/52, H 01 L 21/90**

(30) Priority: **18.09.85 US 777149   02.06.86 US 869759**

(43) Date of publication of application:
**25.03.87 Bulletin 87/13**

(84) Designated Contracting States:
**AT BE CH DE FR GB IT LI LU NL SE**

(71) Applicant: **ADVANCED MICRO DEVICES, INC.**
**901 Thompson Place P.O. Box 3453**
**Sunnyvale, CA 94088 (US)**

(72) Inventor: **Thomas, Mammen**
**1081 Corvette Drive**
**San Jose California 95120 (US)**

**Weinberg, Matthew**
**111 North Rengstorff**
**Mt. View California 94043 (US)**

(74) Representative: **Sanders, Peter Colin Christopher et al**
**BROOKES & MARTIN High Holborn House 52/54 High**
**Holborn**
**London WC1V 6SE (GB)**

(54) **Bipolar and/or MOS devices fabricated on integrated circuit substrates.**

(57) An improved integrated circuit structure is disclosed comprising bipolar and/or MOS devices formed on the same substrate. Bipolar devices, when present, have at least the emitter and the collector contact portions formed from a polysilicon layer which results in raised contacts. The MOS devices are similarly formed with raised gate contact portions formed from the same polysilicon layer. Metal silicide is formed over at least a portion of the base, source, and drain regions to provide conductive paths to the base, source, and drain contacts. In one embodiment, the base, source, and drain contacts are also raised contacts formed from the same polysilicon layer to permit formation of a highly planarized structure with self-aligned contacts formed by planarizing an insulating layer formed over the structure sufficiently to expose the upper surface of the contacts.

Description

## BIPOLAR AND/OR MOS DEVICES FABRICATED ON INTEGRATED CIRCUIT SUBSTRATES

This invention relates to the fabrication of bipolar and/or MOS devices on an integrated circuit substrate. More particularly, this invention relates to the production of a fast bipolar transistor and/or at least one MOS transistor on a substrate using self-aligned raised polysilicon contacts for at least some of the electrodes.

In the construction of integrated circuits, the active devices usually comprises either bipolar or MOS type devices. Bipolar devices may be chosen instead of MOS due to their high current carrying characteristics and superior transconductance of the devices. On the other hand, the use of MOS devices. in preference to bipolar devices, usually occurs when either the low power consumption or high density characteristics of MOD devices are needed or desired.

In many instances, it would be most desirable to use both types of devices in an integrated circuit structure to achieve certain desired effects, e.g., fast logic and low power storage. However, this may be difficult due to the differences in the techniques which have evolved to construct bipolar and MOS devices; particularly when such techniques may be addressed toward remedying a problem which is peculiar to one particular device.

For example. in the construction of bipolar devices, the spacing between the emitter and the base contact in prior art bipolar transistors is defined by lithography and isolated by oxide. This makes it necessary to have a high dose implanted or diffused extrinsic base region under the oxide which acts as the interconnect between the intrinsic base and the base contact. This high doping of the extrinsic base region results in unacceptable increases in capacitance between the base and the buried collector. This problem becomes particularly acute when the thickness of the epitaxial layer between the base and the buried collector is reduced for improved performance which results in the base butting against the buried collector layer to thereby raise the capacitance and slow down the speed of the device.

Furthermore, since the resistance of the doped extrinsic base region still does not approach the conductivity of polysilicon or metal, the minimum base resistance of the extrinsic base region, i.e., the resistance of the extrinsic base between the intrinsic base and the base contact, is always a factor degrading performance of such a device.

Another problem in prior art bipolar devices which adversely impacted the speed of such devices was the side diffusion of the highly doped extrinsic base into the emitter which reduced the emitter area and thereby prevented shrinking of the emitter area which would other wise be desirable to improve performance of the device by reducing the capacitance between the emitter and the intrinsic base beneath the emitter. Furthermore, in conventional emitter construction, sidewall capacitance cannot be reduced to gain performance improvement.

Conventional construction of single crystal emitters further limits the gain of the device as well as reducing the ability to provide a shallow emitter without incurring problems of reverse injection of carriers from base to emitter.

In our prior U.S. patent application Serial No. 747,517, filed June, 21, 1985, and entitled FAST BIPOLAR TRANSISTOR FOR INTEGRATED CIRCUIT STRUCTURE AND METHOD OF MAKING SAME, cross reference to which is hereby made, we described and claimed a structure having a raised polysilicon emitter contact with oxide spacers on the sidewalls and a metal silicide conductive path on the surface between the base contact and a point adjacent the oxide spacer to provide a faster device with higher gain and lower capacitance and resistance. In one embodiment in that application, the provision of a raised base electrode is also disclosed which provides an advantage in planarization which results from forming all of the contacts in approximately the same plane by the raising of the base contact.

MOS devices are usually constructed in a non planarized fashion with steps created when making contact with the source and drain regions which are lower than the gate region. Also, despite the high density of the MOS devices, the gate contact usually occupies a large area due to the need to make the contact in a position offset to the gate region because of alignment problems.

Furthermore, in the construction of MOS devices, the source and drain junctions may be formed too deep causing the junctions to sometimes extend under the gate region causing overlap capacitance which degrades the performance of the device. The extension of the junction under the gate may be caused by forming the junction too deeply in the substrate. This can also cause the depletion region to extend sideways into the channel causing a short channel effect which further degrades the performance and functionality as well as long term reliability. If the source and drain regions can be formed as shallow junctions, which do not extend laterally, e.g., beneath the gate, the junction capacitance may also be lowered because of the reduction in the junction area.

It would, therefore, be very desirable to be able to fabricate bipolar and MOS devices on a substrate in a manner which would address some or all of the problems of each of the particular devices discussed above.

In the present specification there is described an improved integrated circuit structure containing bipolar and/or MOS devices characterised by fast operation, low power consumption, and low capacitance and a method of making same. At least some of the electrode contacts are formed using polysilicon with self-aligned contacts.

The bipolar and/or MOS devices have a metal silicide layer over a portion of at least some of the electrode contacts to raise the current carrying capability of the MOS devices and to lower the base resistance of any bipolar devices present. Oxide spacers are formed adjacent the sidewalls of the raised polysilicon emitter and/or gate electrodes.

Planarization techniques are used to provide separate contacts to the electrodes of the devices.

The bipolar and/or MOS devices have raised polysilicon source and drain contacts which may be opened simultaneously with the opening of the gate contact, as well as the base, emitter, and collector contacts when a bipolar device is present, to eliminate steps to any of the contacts.

In accordance with one embodiment of the invention, an improved integrated circuit structure is provided comprising one or more MOS devices, each having a polysilicon gate with oxide spacer portions formed on the sides of the gate and self-aligned contacts to the gate electrode. The structure may also contain one or more bipolar devices, each having a polysilicon emitter formed over a base region of a silicon substrate with oxide spacer portions formed on the sides of the emitter and self-aligned contacts formed to both the collector and emitter electrodes.

In another embodiment of the invention, the improved integrated circuit structure comprises one or more MOS devices, with or without a bipolar device, wherein each MOS device has a raised polysilicon gate with oxide spacer portions formed on the sides of the gate contact and raised source and drain contacts with metal silicide coatings on the side surfaces of the raised source and drain contacts as well as adjacent portions of the source and drain regions to promote conductivity and provide a highly planarized structure. If bipolar devices are also present, the base, emitter, and collector contacts are also raised to provide enhanced planarization of the structure after formation of the active devices.

In the accompanying drawings, by way of example only:-

Figure 1 is a fragmentary vertical cross-sectional view illustrating an early stage of the construction of an integrated circuit structure embodying the invention containing both a bipolar device and MOS devices.

Figures 2-10 are fragmentary vertical cross-sectional views illustrating subsequent stages of the construction of the integrated circuit illustrated in Figure 1.

Figures 11-16 are fragmentary vertical cross-sectional views illustrating subsequent stages in the construction of another integrated circuit embodying the invention.

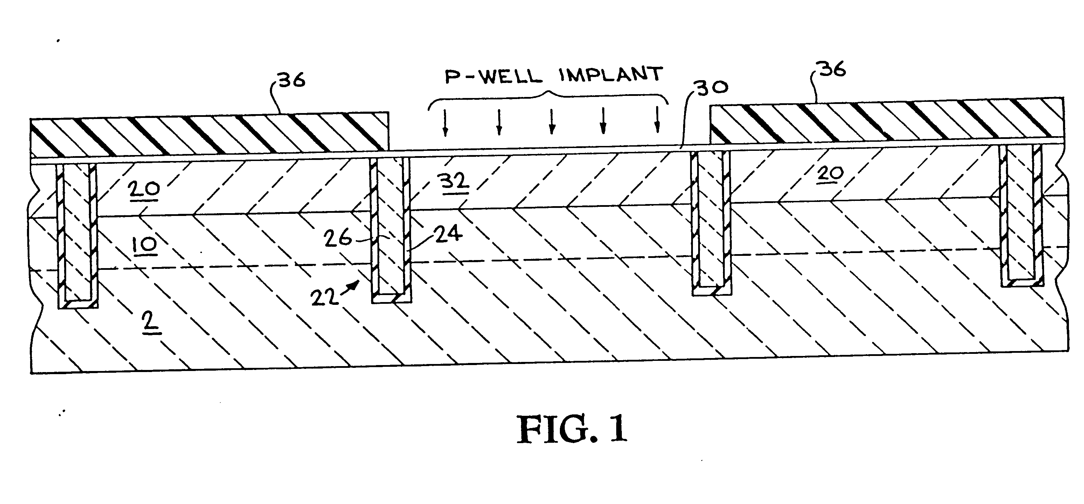

Referring now to Figure 1-10, construction of one embodiment of the invention will be illustrated. While the invention is applicable both to integrated circuit structures containing only MOS devices and to structures containing both MOS and bipolar devices, the construction of an integrated circuit structure containing both bipolar and MOS devices on the same substrate will be illustrated. It will be understood, however, that the same applicable MOS device formation steps may be used to construct an all MOS structure as well.

In Figure 1, a buried collector 10 is shown as already formed in silicon substrate 2 with an epitaxial silicon layer 20 grown over buried collector 10 and a thin buffer layer 30 of oxide, e.g., about 300 Angstroms, applied over epitaxial layer 20. Buried layer 10 may extend over the entire substrate as shown, or may be formed only in the bipolar region by appropriate masking.

Isolation slots 22 may then be formed which extend down from the surface through epitaxial layer 20 and buried layer 10 into substrate 2. Slots 22 may be lined with an isolation oxide 24 and then filled at 26 with polysilicon.

The areas in which will be formed the bipolar and PMOS devices are than masked at 36, e.g., with a photoresist mask, to permit P implantation into the N epitaxial layer 20 to form P well 32.

It should be noted here, that while a slot type of isolation is illustrated here, other forms of isolation such as isoplanar or junction isolation may also be used in connection with the practice of this invention.

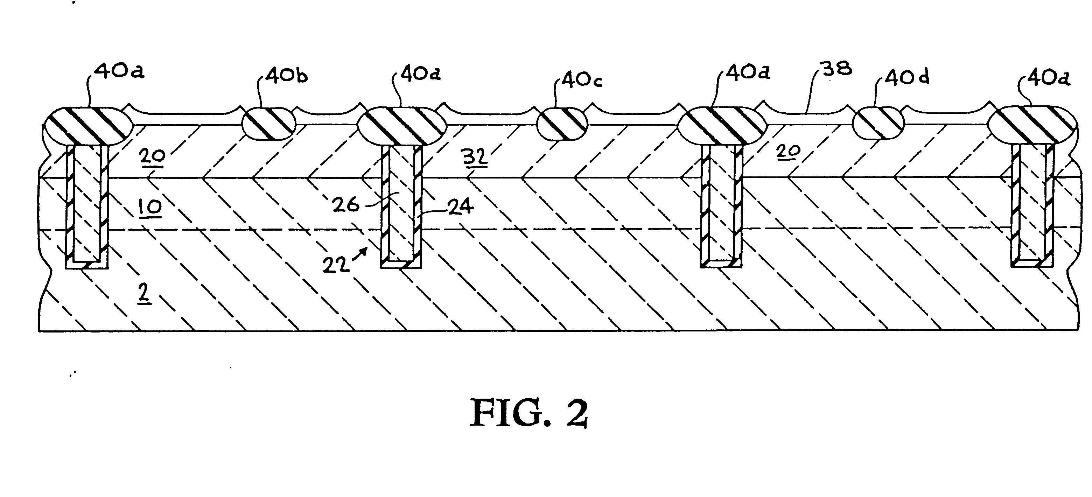

P well mask 36 is then removed and epitaxial layer 20 is covered with a nitride layer 38, as shown in Figure 2, which is then appropriately masked to permit growth of field oxide isolation areas 40a, 40b, 40c, and 40d. The field oxide areas 40a which are formed over slots 22 cooperate with the slots to separate adjacent devices of different types, e.g., to separate bipolar from PMOS, and PMOS from NMOS. Field oxide 40b serves to separate the base contact of the bipolar device from the collector contact. Field oxide 40c separates adjacent NMOS devices and field oxide 40d separates adjacent PMOS devices.

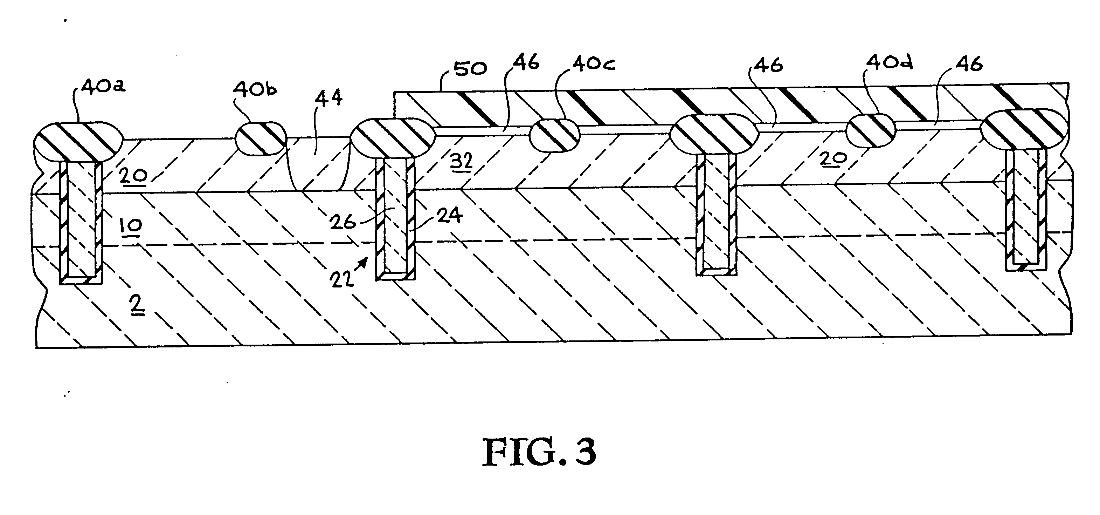

Nitride layer 38 is then masked to open up sinker 44 as shown in Figure 3 which is then formed by an N+ implantation to form the N+ sinker which will provide the connection to buried collector layer 10.

After formation of sinker 44, nitride layer 38 is stripped off. A gate oxide layer 46 is then formed on the surface of epitaxial layer 20 which is partially removed by masking the MOS areas with photoresist mask 50 to permit removal of gate oxide layer 46 from the bipolar regions of the structure as shown in Figure 3.

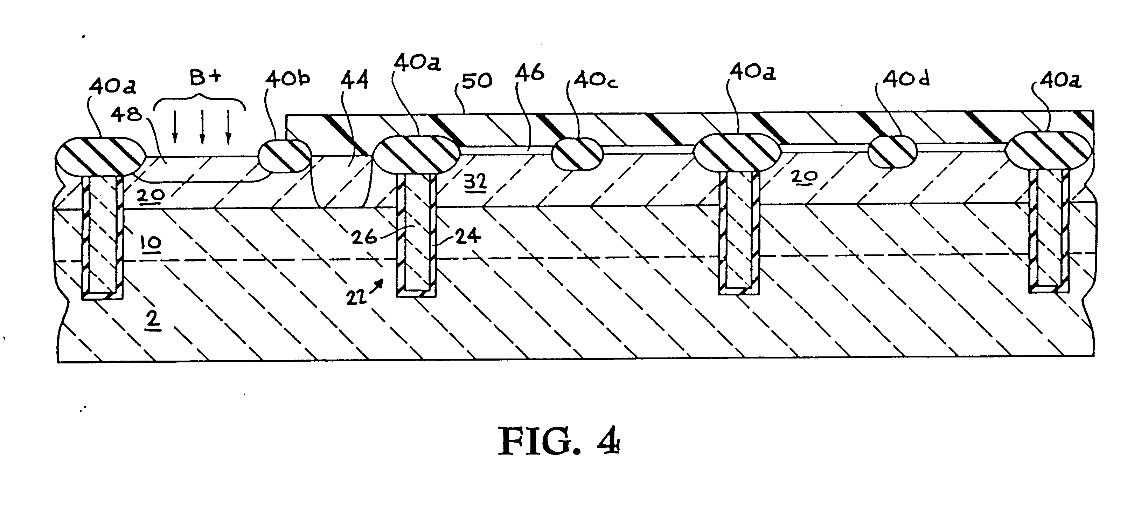

After removal of the gate oxide layer 46 in the bipolar region, the surface of sinker 44 is also masked, as shown in Figure 4, and the remainder of the bipolar region is doped, e.g., by a P+ implantation, with boron, to form P doped intrinsic base region 48 shown in Figure 4. Alternatively, the P+ implantation may be done before the gate oxide is stripped in the bipolar region.

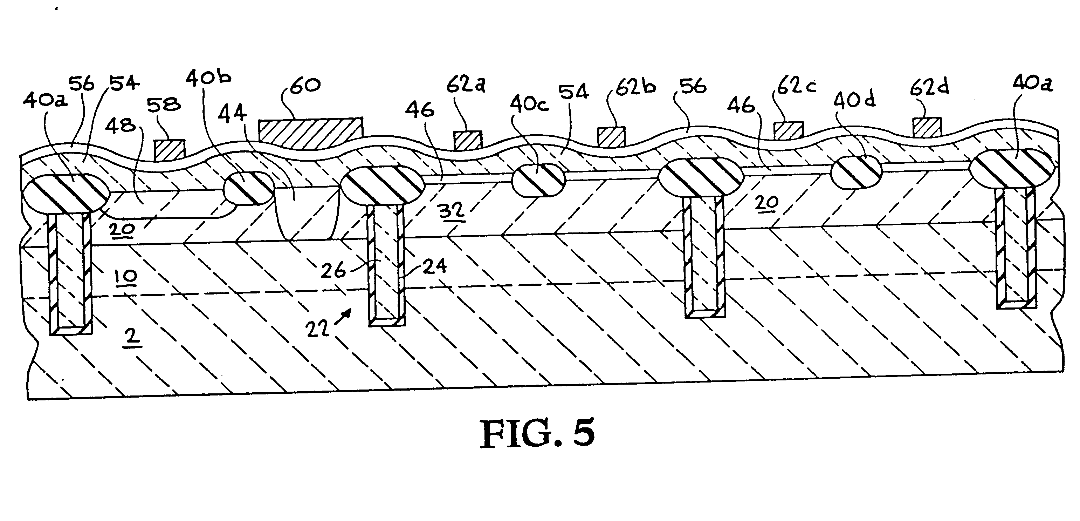

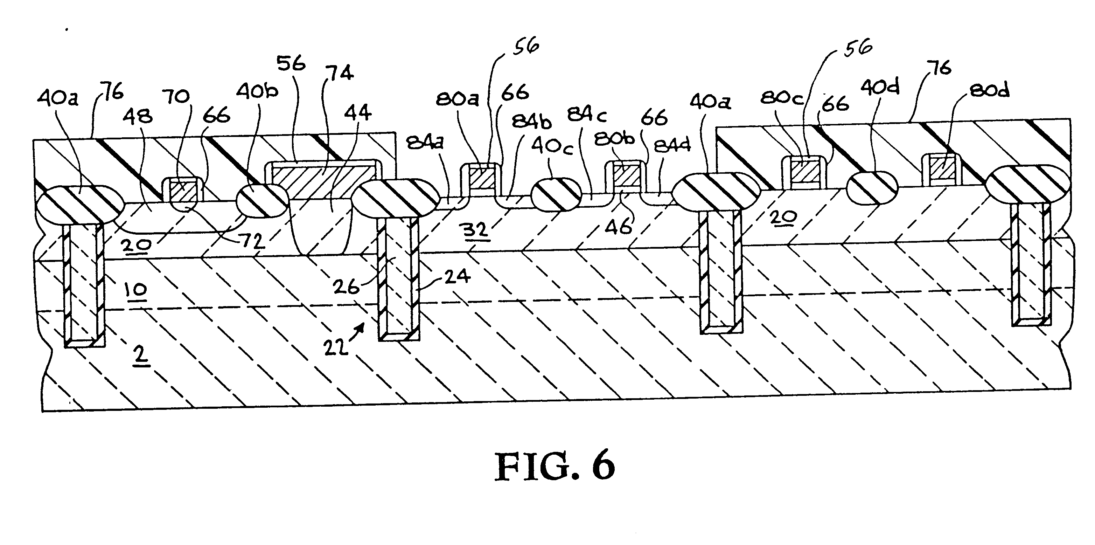

As shown in Figure 5, mask 50 is then removed and a 3000-5000 angstrom polysilicon layer 54 is formed over the entire surface followed by application of a nitride layer 56 thereover. Polysilicon layer 54 is doped with an N dopant, such as, for example, a $POCl_3$ diffusion or an Arsenic+ implant, to form an N+ layer. In one embodiment of the invention, polysilicon layer 54, and nitride layer 56 thereon, are then masked to define the emitter at 58, the collector at 60 and the gates at 62a, 62b, 62c, and 62d. The remainder of polysilicon layer 54 and underlying nitride layer 38 are plasma etched away leaving, as shown in Figure 6, raised polysilicon emitter contact 70, raised polysilicon collector contact 74, and raised polysilicon gate contacts 80a, 80b, 80c, and 80d.

The now exposed gate oxide 46 over the source and drain regions may now be removed using an etchant such as, for example, a $NH_3$ - Acetic acid etch. A 300 Angstrom protective layer of oxide 66 is then grown on the now exposed sides of the polysilicon contacts 70, 74, 80a, 80b, 80c, and 80d with the remainder of nitride layer 56 providing a mask for the top surfaces of the raised contacts. The heat used for this growth, i.e., about 1000'C for about 10-20 minutes, also serves to lightly diffuse doped emitter contact 70 into intrinsic base region 48 to form emitter region 72 in intrinsic base region 48.

The bipolar and PMOS regions are then masked with a photoresist mask 76 and lightly doped (LDD) source and drains regions 84a, 84b, 84c, and 84d are formed in P well 32 in the NMOS region by an N-implant as shown in Figure 6.

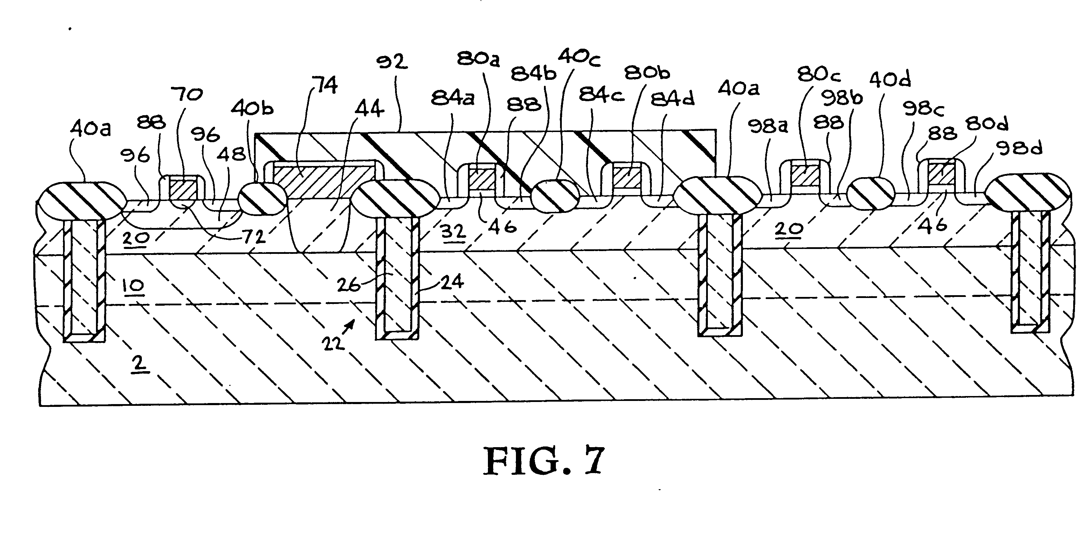

Turning now to Figure 7, photoresist mask 76 is now removed and a layer of oxide, from which will be formed the oxide spacers, is then formed over the structure. This oxide is then subjected to a reactive ion etch (RIE) to remove most of the oxide leaving only oxide spacer portions 88 on the sides of the raised polysilicon contacts 70, 74, 80a, 80b, 80c, and 80d. Alternatively, spacers 88 may be grown by differential oxidation wherein the oxide will grow faster on the doped polysilicon comprising raised contacts 70, 74, and 80a-80d than on epitaxial layer 20. Alternatively, spacer 88 may comprise other insulating materials such as nitride.

The NMOS region and the collector contact of the bipolar device are then masked with photoresist 92. A P+ implant, using, for example, $BF_2$, is then made to provide a P+ extrinsic base region 96 in P base 48 on each side of emitter contact 70 in the bipolar region; and to provide source and drain regions 98a, 98b, 98c, and 98d in epitaxial layer 20 in the PMOS region as illustrated in Figure 7.

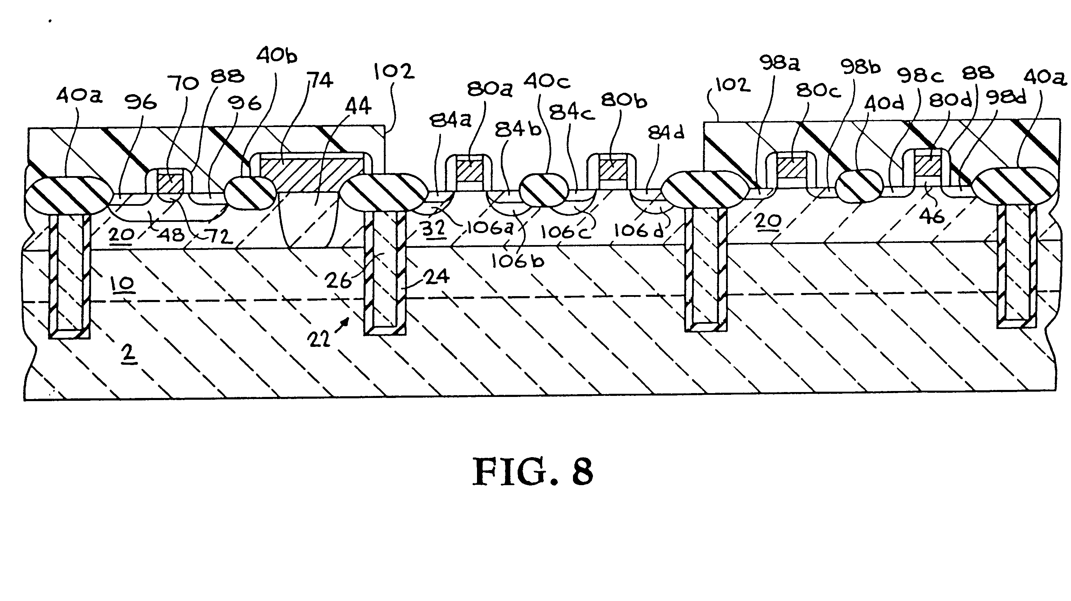

The bipolar and PMOS regions are then masked with photoresist mask 102, as shown in Figure 8, and N+ source and drain regions 106a, 106b, 106c, and 106d are then implanted with arsenic. Photoresist mask 102 is then stripped and an implant anneal is performed, e.g., at 1000'C for 10 minutes, or by a "rapid thermal anneal".

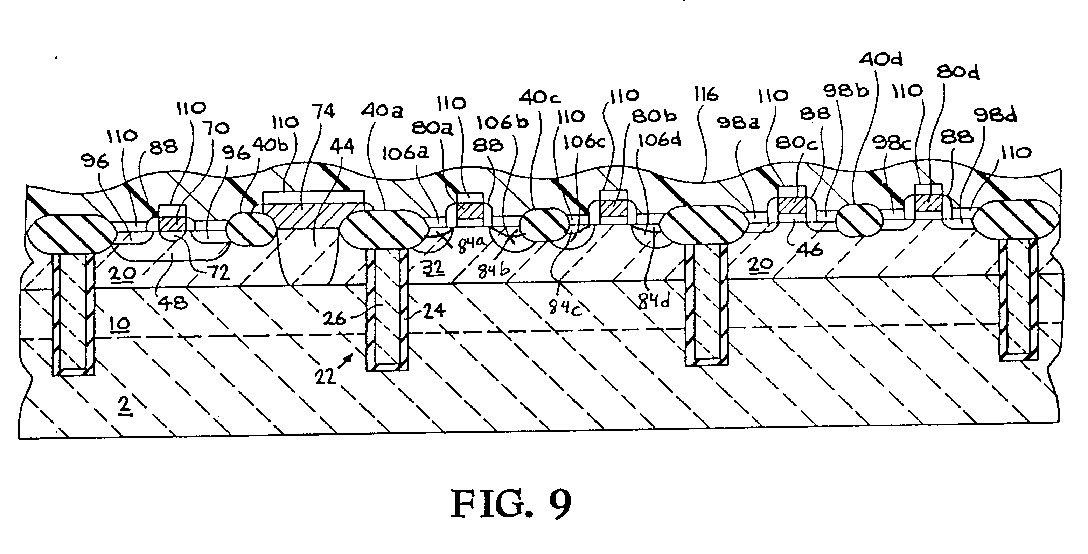

The remaining nitride on the raised emitter, collector, and gate contacts is then stripped and a metal, capable of forming a silicide, such as, for example, platinum, or titanium, is deposited to form metal silicide layer 110 over emitter contact 70, collector contact 74, base contacts 96, the respective gate contacts 80a-80d, NMOS source and drain regions 84a-84d, and PMOS source and drain regions 98a-98d as shown in Figure 9.

Planarization layer 116 is then applied over the structure and planarized to clear the respective raised emitter, collector and gate contacts, i.e., to expose the metal silicide coating 110 on the upper surface of the contacts. Planarization layer 116 may comprise an oxide, a nitride, or a polyimide, or any combination thereof, or any other insulation material.

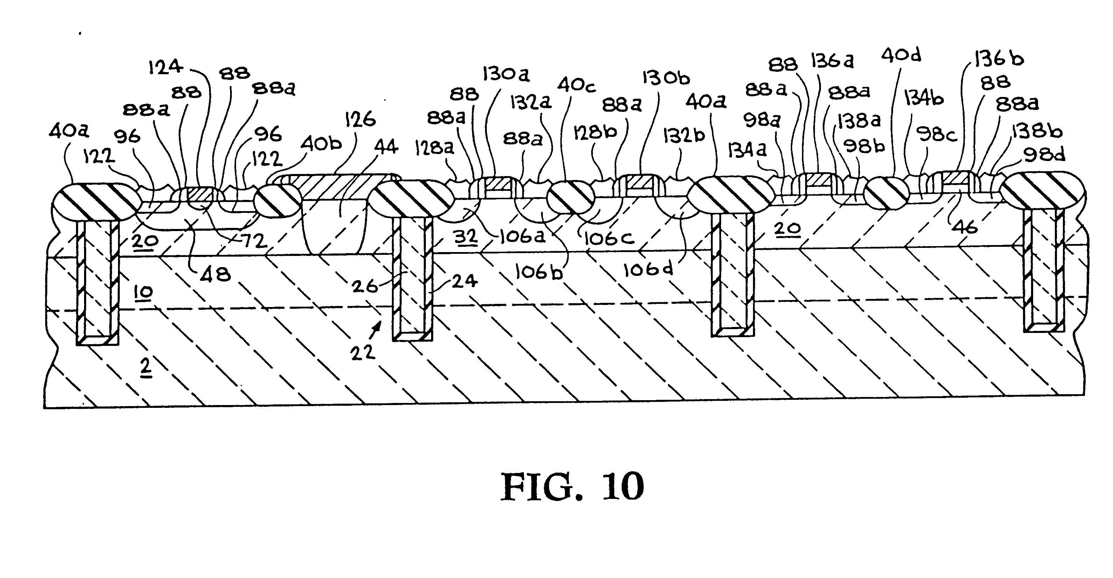

The structure is then blanket etched, as shown in Figure 10, to clear the base, source, and drain contacts. When planarization layer 116 is etched in this manner, additional spacer members 88a, comprising remnants of planarization layer 116, are left adjacent spacers 88, as further shown in Figure 10. Spacers 88a act in conjunction with spacers 88 to separate the contacts from one another.

Alternatively, these contacts may be "cut" by opening vias onto the silicide. A metal layer, e.g., a 0.8 micron layer of aluminum over a barrier layer of TiW, is then deposited over the structure and masked to provide metal contacts 122, 124, and 126 in the bipolar region; source contacts 128a and 128b, gate contacts 130a and 130b, and drain contacts 132a and 132b in the NMOS region; and source contacts 134a and 134b, gate contacts 136a and 136b, and drain contacts 138a and 138b in the PMOS region.

The foregoing describes one embodiment of the invention wherein the use of oxide spacers on the sides of both the emitter and the gate, coupled with the removal of the gate oxide over the source and drain, and the use of metal silicide over the contacts provides a more compact structure with self aligned contacts.

However, in yet another embodiment, as will be explained below, the techniques described may be also used to provide a structure which is highly planarized due to the provision of all of the electrodes with raised polysilicon contacts. The concepts of this embodiment, as in the embodiment just described, may be applied to a structure comprising only MOS type active devices or to structures having both MOS and bipolar devices, i.e., having raised base, source, and drain contacts as well as the raised emitter, collector, and gate contacts described in the preceding embodiment.

Construction steps of the structure of this embodiment will, therefore, be described for the formation of both MOS and bipolar devices on the same substrate, it being understood that the same procedure can be used to construct an all MOS type structure.

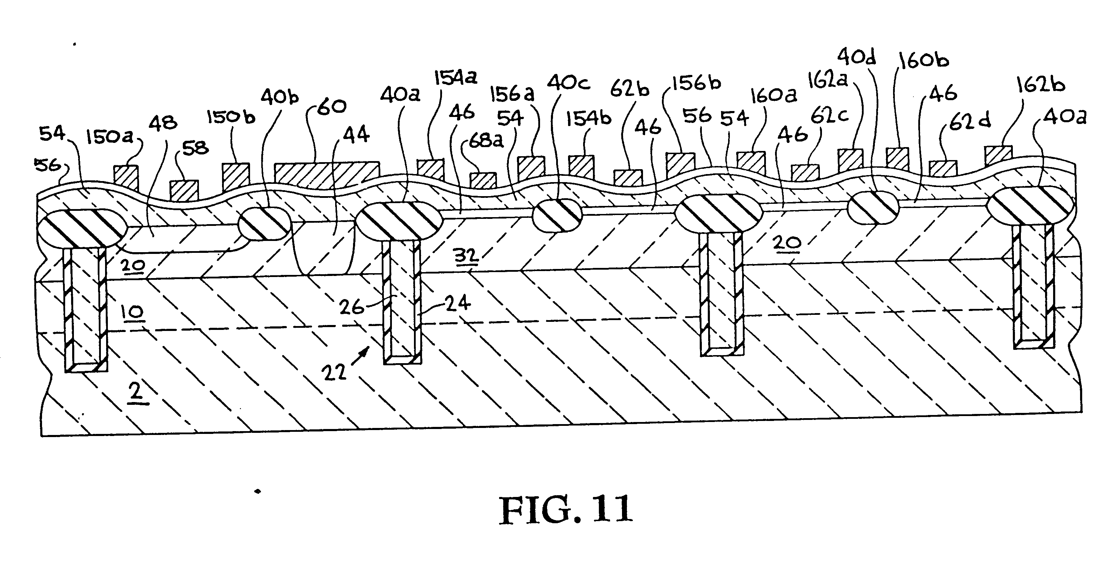

Turning now to Figure 11, the structure previously described in Figures 1-4, is masked somewhat differently from the mask of Figure 5 in the previous embodiment in that base masks 150a and 150b are also provided as well as NMOS source masks 154a and 154b, NMOS drain masks 156a and 156b, PMOS source masks 160a and 160b, and PMOS drain masks 162a and 162b.

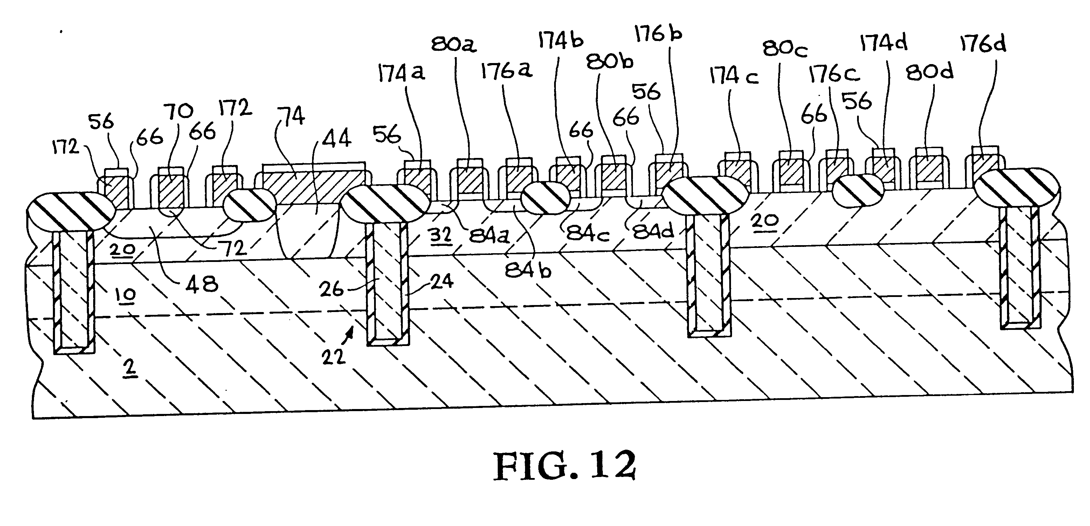

The remainder of the polysilicon is then removed as well as the underlying nitride layer as in the previously described embodiment leaving a raised polysilicon base contact 172, raised polysilicon emitter contact 70, raised polysilicon collector contact 74, raised polysilicon source contacts 174a-174d, raised polysilicon gate contacts 80a-80d, and raised polysilicon drain contacts 176a-176d as shown in Figure 12.

At this point the exposed portions of gate oxide layer 46 over the source and drain regions (in between the raised polysilicon source and gate contacts or in between the raised polysilicon gate and drain contacts) may be removed.

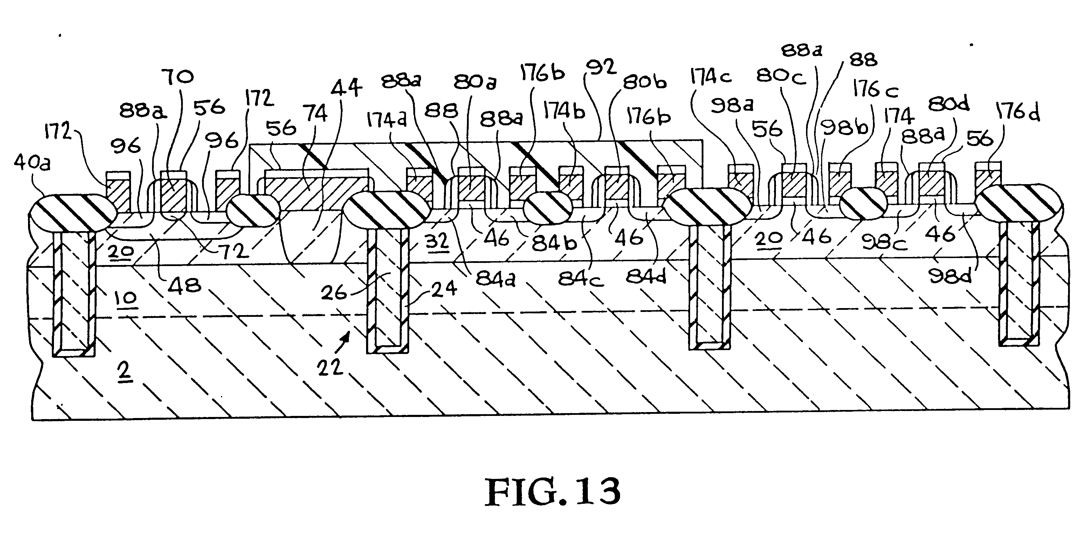

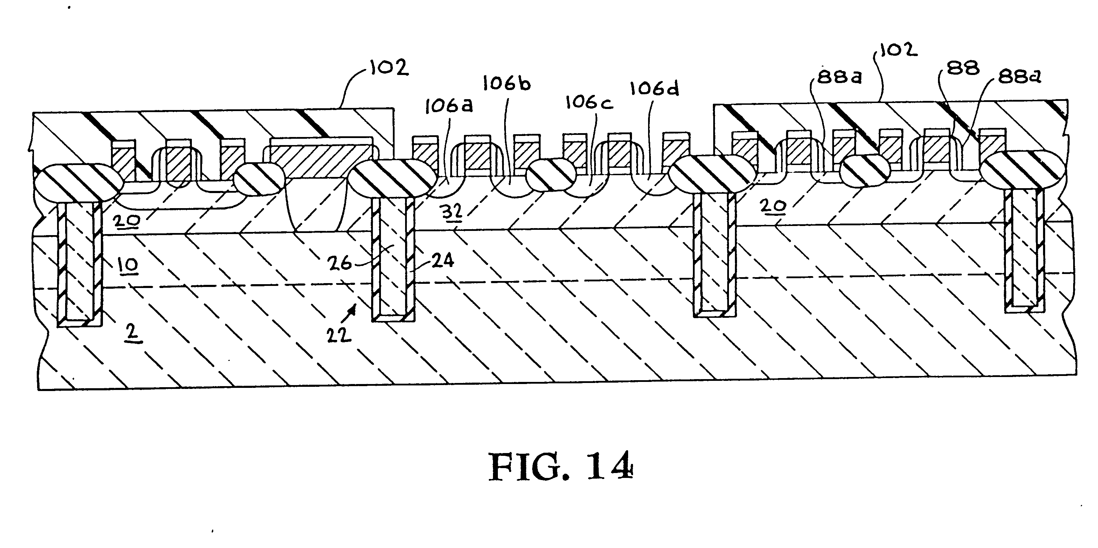

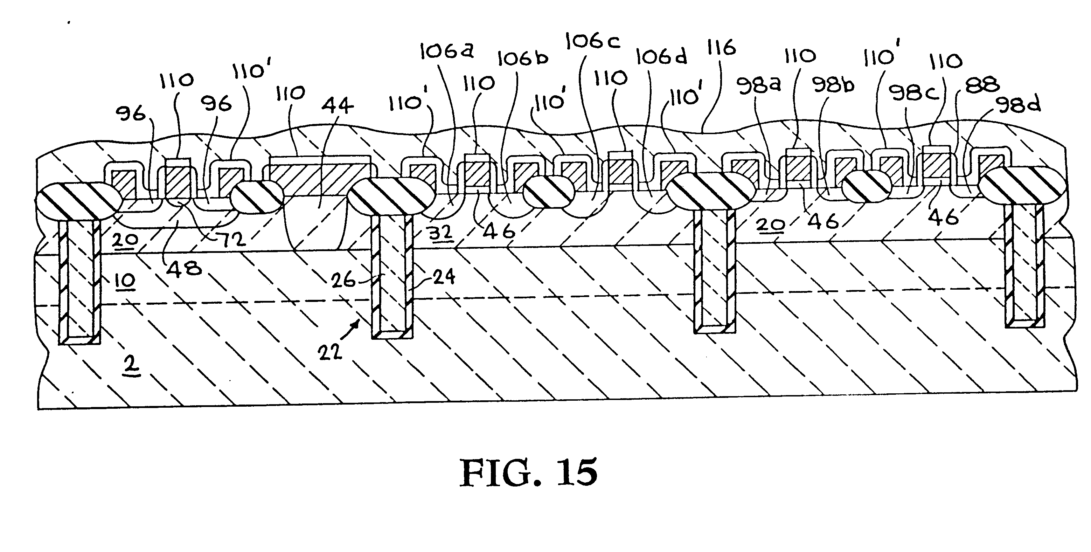

The resultant structure is then processed in Figures 13-15 in similar fashion to the process steps described and illustrated in Figures 7-9 to form oxide spacer 88 on the sidewalls of the raised polysilicon contacts. However, as shown in Figures 13 and 14, since all of the contacts are now raised in this embodiment, the oxide spacers, formed on the sides of the raised base, source and drain contacts, are removed prior to the implantation steps by appropriate masking of the emitter, collector, and gate regions. The respective areas in Figures 13 and 14 are then masked in similar fashion to that shown for Figures 7 and 8 to form the respective source and drain implants in the PMOS and NMOS regions as well as the P+ base implantation in the bipolar region.

The silicide step then forms a conductive coating or layer of silicide 110' on the top and sides of the raised polysilicon base, source, and drain contacts as well as over the extrinsic base region 96 and over the source and drain regions to provide low resistance current paths to the respective raised electrode contacts.

As in the previous embodiment, a layer of oxide 116 is then formed over the structure after the siliciding step. However, unlike the prior embodiment, subsequent planarization opens all the contacts making further selective etching to clear the base, source, and drain contacts unnecessary.

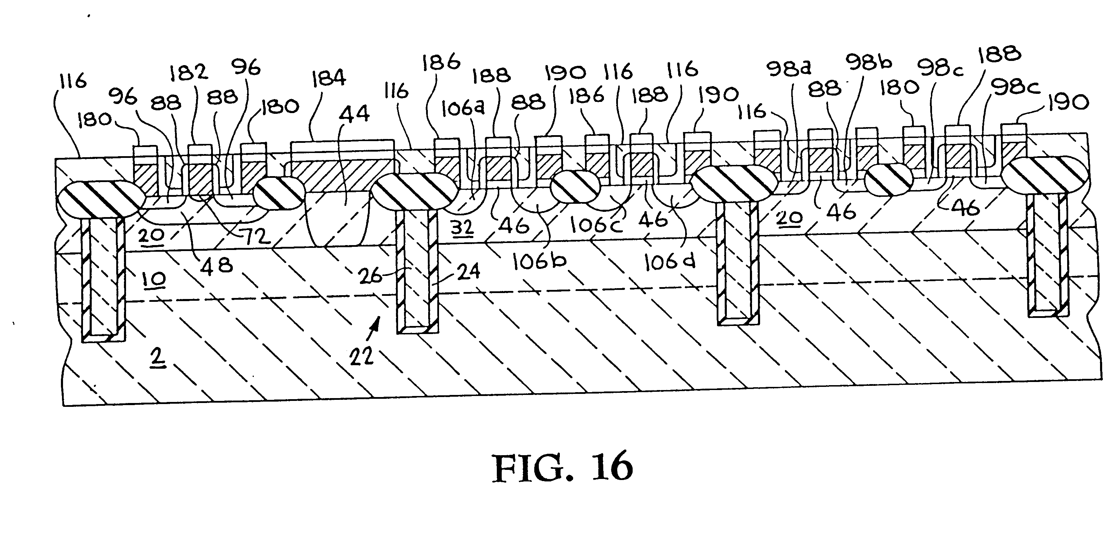

The final metallization and masking steps then form metal base contact 180, metal emitter contact 182, metal collector contact 184, metal collector contacts 186, metal gate contacts 188, and metal drain contacts 190. The resultant structure, as seen in Figure 16, is a highly planarized structure with all self aligned contacts.

The resulting integrated circuit structure of the invention provides an improved construction of the MOS devices which facilitates the formation of contacts thereto without cutting through the passivation glass to reach the source and drain regions thereby eliminating the critical alignment and process tolerance associated with via contacts. The gate resistance is lowered by using a polysilicon gate with direct contact to the gate polysilicon over the channel instead of bringing the contact to the side of the channel. In addition, the use of the self aligned gate contacts permits a more compact construction by eliminating the need for protective oxides around cut areas.

When a combination of bipolar and MOS devices are both constructed on the same substrate using the techniques of the invention, the bipolar devices operate faster due to the low resistance between the intrinsic base and the base contact with high base resistance only under the emitter and oxide spacers since the remainder of the base is in contact with the metal silicide, thus effectively eliminating the relatively high resistance and high collector-base capacitance of the extrinsic base regions of prior art devices. The use of polysilicon emitters also results in a device having higher gain by preventing reverse injection of minority carriers from the base to the emitter.

Finally, the use of all raised polysilicon electrode contacts with metal silicide conductive paths thereon, in one embodiment of the invention, results in the provision of a very planarized structure possessing high speed and low resistance and capacitance.

**Claims**

1. An integrated circuit structure characterized by an improved active device thereon having at least one raised polysilicon contact portion with oxide spacers means 88 on the sidewall thereof and a metal silicide layer 110 formed over the top surface of said raised contact portion as well as the top surfaces of adjacent electrode regions of the active device wherein the separations between said raised contact portion and contact means to said adjacent electrode regions are formed by a self-aligning process whereby the spacing between said raised polysilicon contact portion and said adjacent electrode contact means is reduced thereby permitting horizontal shrinkage of said active device.

2. The structure of claim 1 wherein said metal silicide 110 over said adjacent electrode regions provide conductive paths adjacent said oxide spacer means 88 on the sidewall of said raised polysilicon contact portion leading to said adjacent electrode contact means.

3. The structure of claim 2 wherein said active device is an MOS device and said raised polysilicon electrode portion comprises a raised gate electrode 80 having oxide spacers 88 on the sidewall thereof.

4. The structure of claim 3 also having constructed thereon one or more bipolar devices characterized by a raised polysilicon emitter contact portion (70) to provide high gain and oxide spacer means (88) on the sidewall of said raised polysilicon contact portion of said emitter, and base contact means comprising metal silicide conductive portions (110) adjacent oxide spacer means (88) whereby the speed of said bipolar device is enhanced by decreasing the resistance path between the intrinsic base 48under the emitter and said conductive portion of said base contact means.

5. The structure of claim 2 wherein said adjacent electrode contact means of said active device also comprise raised polysilicon portions and at least a portion of said conductive paths to said adjacent raised polysilicon contact means are respectively located over segments of said adjacent electrode regions between said adjacent raised polysilicon contact means and said oxide spacers (88) on the sidewall of said raised polysilicon contact; a planarizing layer (116) of insulating material is placed over said active device; and said structure is planarized to provide self-aligned openings therethrough at approximately the same height for al of said raised polysilicon contacts; whereby said active device is further characterized by the substantial absence of steps.

6. The structure of claim 5 wherein said active device is an MOS device, said raised polysilicon electrode portion comprises a raised gate electrode (80) having oxide spacers (88) on the sidewall thereof, and said adjacent raised polysilicon contacts comprise raised polysilicon source contacts (174) and raised polysilicon drain contacts (176) for the respective source and drain regions, whereby said conductive path portions of metal silicide (110) interconnect said source and drain regions with said raised polysilicon source and drain contacts.

7. The structure of claim 6 also having constructed thereon one or more bipolar devices characterized by a raised polysilicon emitter contact portion (70) to provide high gain and oxide spacer means (88) on the sidewall of said raised polysilicon contact portion of said emitter, a raised polysilicon collector contact portion (74), and raised polysilicon base contact means (172) in electrical contact with metal silicide conductive portions (110) adjacent oxide spacer means (88) whereby the provision of all raised electrode contacts provides a planar structure.

8. The structure of claim 7 wherein said decrease in the resistance between the intrinsic base (48) under emitter region (72) and said raised polysilicon base contact means (174) in said bipolar device results, at least in part, from at least partial elimination of extrinsic base region (96) and replacement with metal silicide portions (110) thereby increasing the speed of said device.

9. The improved integrated circuit structure of claim 8 wherein said partial elimination of extrinsic base region (96) in said bipolar device results in decreased doping migration into said emitter which permits polysilicon emitter area (72) over said intrinsic base (48) to be reduced without reducing the current carrying ability of said emitter to thereby lower the emitter-base capacitance and thereby increase the speed of said device.

10. The structure of claim 9 wherein the epitaxial layer of silicon in said structure between said raised polysilicon emitter contact portion (70) and a buried collector region (10) is reduced due to the partial elimination of extrinsic base region (96) without reducing the spacing between said buried collector region (10) and the intrinsic base region (48) formed in said epitaxial silicon beneath said emitter (72) whereby the vertical size of said device may be reduced without increasing the base-10 collector capacitance.

11. The structure of claim 1 where said raised silicon contact is formed by depositing a layer of polysilicon on a substrate; doping said polysilicon sufficiently to alter the conductivity to permit formation of said electrode contact therefrom; masking said doped polysilicon to define said electrode contact; and removing the remainder of said polysilicon.

12. The structure of claim 1 wherein said oxide spacers on the sidewalls of said raised polysilicon contact are formed by heating said structure sufficiently to form a protective oxide layer on the sidewalls of said raised polysilicon contacts; and forming insulating spacers over said protective oxide layer on the sidewalls of said raised electrode contact portions by depositing a layer of insulating material over said structure; and removing portions of said insulating material by a reactive ion etch which will leave said insulating spacer on the sidewalls of said polysilicon electrode contact portion.

13. The structure of claim 3 constructed by forming a gate oxide over at least a portion of the surface of said substrate; removing said gate oxide from the surface of a portion of said substrate; forming a layer of doped polysilicon over said structure; masking said polysilicon to define a gate contact portion and removing the remainder of said polysilicon; forming insulating spacers adjoining the sidewall of said polysilicon gate contact portion; removing gate oxide from further portions of said substrate surface to expose portions of said substrate corresponding to said source and drain regions; forming a metal silicide over said raised gate contact portion and said source and drain regions; forming a further layer of an insulating material over said structure; and planarizing said structure to remove sufficient insulating material to expose the top portion of said raised polysilicon contact portion.

14. The structure of claim 4 constructed by depositing a layer of polysilicon on said substrate; doping said polysilicon sufficiently to alter the conductivity to permit formation of said electrode contacts therefrom; masking said doped polysilicon to define emitter, collector, and gate electrode contact portions; removing the remainder of said polysilicon; forming an insulating spacer adjoining the sidewall of said raised emitter contact portion and an insulating spacer adjoining the sidewall of said raised gate contact portion; and forming conductive path portions adjacent said spacers from base, source, and drain regions in said substrate to other electrode contacts to thereby lower the resistance path between said base, source, and drain regions and said electrode contacts.

15. The process described in Claim 14 wherein said step of forming said raised emitter contact portion, said raised collector contact portion, and said raised gate contact portion comprises forming said raised contact portions from a single layer of polysilicon on said substrate.

16. The process described in claim 15 wherein said step of locating a conductive path portion of another electrode contact means adjacent at least one of said spacers comprises forming base contact means having a conductive path portion adjacent the insulating spacer adjoining said raised emitter contact portion; forming a source contact means having a conductive path portion adjacent said insulating spacer adjoining said raised gate portion; and forming a drain contact means having a conductive path portion adjacent said insulating spacer adjoining said raised gate portion.

17. The process described in claim 16 wherein said steps of forming said conductive path portions comprises forming a layer of a conductive metal silicide to provide a lower resistance path to said electrode contact means.

18. The structure of claim 5 wherein said raised electrodes are formed by depositing a layer of polysilicon on said substrate; doping said polysilicon sufficiently to alter the conductivity to permit formation of said electrode contacts therefrom; masking said doped polysilicon to define said raised polysilicon electrode contacts; and removing the remainder of said polysilicon.

19. The structure of claim 6 wherein said raised electrode contacts are formed by depositing a layer of polysilicon on a substrate; doping said polysilicon sufficiently to alter the conductivity to permit formation of said electrode contacts therefrom; masking said doped polysilicon to define said raised source, drain, and gate electrode contacts; and removing the remainder of said polysilicon.

20. The structure of claim 6 formed by depositing a layer of polysilicon on a substrate; doping said polysilicon sufficiently to alter the conductivity to permit formation of said electrode contacts therefrom; masking said doped polysilicon to define said raised source, drain, and gate electrode contacts; removing the remainder of said polysilicon; forming oxide spacer means on the sidewall of said raised gate contact portion; forming a metal silicide conductive layer on the top of said raised contacts, on the sidewalls of said raised source and drain contacts, and on said substrate over said source and drain regions between said oxide spacer means and said raised source and drain contacts to provide a conductive path therebetween; and forming a layer of insulating material over said structure which has been planarized to expose the upper surface of said contacts; to thereby form said improved MOS structure characterized by a highly planarized surface with self-aligned contacts.

21. The structure of claim 7 constructed by forming a buried layer in a semiconductor substrate; growing an epitaxial layer of silicon over said buried layer; forming at least one isolation zone in said structure to separate adjoining active devices; forming a gate oxide over at least a portion of the surface of said epitaxial layer; removing said gate oxide from the surface of a portion of said epitaxial layer; forming a sinker in a portion of said epitaxial layer to provide an electrical contact to said buried layer; forming an intrinsic base in one portion of said epitaxial layer separated from said sinker by an isolation zone; forming a layer of doped polysilicon over said structure; masking said polysilicon to define emitter, collector, base, source, drain, and gate contact portions and removing the remainder of said polysilicon; doping exposed portions of said epitaxial layer to form said source and drain regions; forming oxide spacers adjoining the sidewall of said polysilicon emitter and gate contact portions; removing gate oxide from further portions of said substrate surface to expose portions of said epitaxial layer corresponding to source and drain regions; forming a metal silicide over said raised polysilicon emitter, collector, base, source, drain, and gate contact portions, said source and drain regions, and said intrinsic base region; forming a layer of an insulating material over said structure; and planarizing said structure to remove sufficient insulating material to expose the top portion of said raised emitter, collector, base, source, drain, and gate contact portions to thereby open up self-aligned contacts to said electrodes.

P-WELL IMPLANT

36 30 36

↓ ↓ ↓ ↓ ↓

20 32 20

26 24

10

22

2

FIG. 1

**FIG. 2**

40a 40b 40a 40c 40a 38 40d 40a

20 32 20

10 26 24

22

2

FIG. 3

**FIG. 4**

**FIG. 5**

FIG. 6

FIG. 7

FIG. 8

FIG. 9

FIG. 10

FIG. 11

FIG. 12

**FIG. 13**

FIG. 14

**FIG. 15**

FIG. 16